# EUROPEAN PATENT SPECIFICATION

(11) **EP 4 407 676 B1**
(45) Date of publication and mention of the grant of the patent: **25.11.2026**
(21) Application number: 23790887.6
(22) Date of filing: 01.03.2023
(51) Int. Cl.: H10W 40/25, H10W 42/00, H10W 70/65, H10W 70/68, H10W 76/138, H05K 3/341, H05K 1/00

(54) **POWER MODULE AND VEHICLE-MOUNTED POWER CIRCUIT**
LEISTUNGSMODUL UND FAHRZEUGMONTIERTE LEISTUNGSSCHALTUNG
MODULE DE PUISSANCE ET CIRCUIT DE PUISSANCE MONTÉ SUR VÉHICULE

(30) Priority: 18.04.2022 CN 202210406560
(43) Date of publication of application: 31.07.2024
(73) Proprietor: Huawei Digital Power Technologies Co., Ltd., Shenzhen, Guangdong 518043 (CN)
(72) Inventor: CHEN, Huibin, Shenzhen, Guangdong 518043 (CN); WANG, Yutao, Shenzhen, Guangdong 518043 (CN); LIU, Haiyan, Shenzhen, Guangdong 518043 (CN); CHEN, Song, Shenzhen, Guangdong 518043 (CN); YIN, Zhonghua, Shenzhen, Guangdong 518043 (CN); LV, Zhen, Shenzhen, Guangdong 518043 (CN); WANG, Zhaoyue, Shenzhen, Guangdong 518043 (CN); YANG, Qiliang, Shenzhen, Guangdong 518043 (CN)
(74) Representative: Isarpatent
(86) International application number: PCT/CN2023/078978
(87) International publication number: WO 2023/202224

(56) References cited:
- CN-A- 1 501 490
- CN-A- 109 663 998
- CN-A- 112 736 058
- CN-A- 114 975 342
- JP-A- 2005 101 353
- JP-A- 2012 182 279
- JP-A- 2012 182 279
- JP-A- 2013 093 355
- KR-A- 20040 026 129
- US-A1- 2018 102 303
- US-A1- 2022 044 988

## Description

### TECHNICAL FIELD

This application relates to the field of power electronics technologies, and in particular, to a power module and a vehicle-mounted power circuit.

### BACKGROUND

With development of power electronics technologies, a power module has attracted increasing attention. The power module may include a copper-clad substrate and a chip. A copper layer of the copper-clad substrate includes a groove for forming a line. As power density of a power component continuously increases, an internal structure of the power module becomes more compact, so that a distance between the chip and an edge of the groove is increasingly small.

Inside the power module, the chip is usually interconnected with the copper-clad substrate through welding with solder. In a high-temperature welding process between the chip and the copper-clad substrate, heat may be transferred to the copper layer of the copper-clad substrate through the solder, and the copper-clad substrate inevitably undergoes warpage deformation. Deformation amounts of different modules vary slightly. As a result, warpage between the chip and the copper-clad substrate, a thickness of the solder, a distance between the solder and the edge of the groove, and the like are difficult to accurately control, and the edge of the groove near the chip bears large stress. To ensure sufficient solder, an amount of solder is slightly excessive. Because the distance between the chip and the adjacent groove is close, the solder easily overflows into a gap between the chip and the edge of the groove, and stress concentration is easy to occur on the edge of the groove, resulting in separation of the copper layer. As a result, reliability of the power module is poor.
US 2022/044988 A1 describes a soldering structure configured for preventing solder overflow during soldering and a power module, may include a component to be soldered; and a metal layer having a bonding area, to which the component to be soldered is bonded by solder, and a groove portion formed around the bonding area.
JP 2012-182279 A describes an insulation circuit board is formed by brazing a conductive layer on one surface of an insulation plate and a surface of the conductive layer which is the opposite side of a surface brazed on the insulation plate serves as an electronic element mounting surface. A brazing material accumulation part which accumulates the brazing material so as not to contact with the insulation plate is formed on a profile surface which forms a profile of the conductive layer and has a width in the thick direction of the conductive layer. A contact restriction part which has a predetermined width from an end part on the insulation plate side toward the electronic element mounting surface and restricts the contact between the brazing material in the brazing material accumulation part and the insulation plateis provided on the profile surface of the conductive layer. The brazing material accumulation part is formed at an area on the profile surfacewhich is closer to the electronic element mounting surface side relative to the contact restriction part and is composed of a recessed part which is recessed from the contact restriction part.
US 2018/0102303 A1 describes a power module substrate allows prompt heat dissipation from a semiconductor device and avoids separation of a ceramic plate and a copper plate at their joint interface and cracks in the ceramic plate. A power module substrate for mounting a semiconductor device includes a ceramic plate, a copper circuit plate on a main surface of the ceramic plate, and a heat dissipation copper plate on a surface of the ceramic plate opposite to the main surface. The copper circuit plate includes at least one first copper circuit plate and at least one second copper circuit plate different from the first circuit board. The first copper circuit plate includes a first portion on which the semiconductor device is mountable, and a second portion outward from the first portion and surrounding the first portion and thinner than the first portion.
CN 1 501 490 A describes that a groove is made in the peripheral part on the surface of a die pad to surround a region for mounting a semiconductor device. In the production step for mounting the semiconductor device on the die pad through the solder material, the solder material spreads when the semiconductor device is mounted on the fused solder material but the groove functions as a region for blocking outflow.
JP 2005 101353 A describes a ceramics circuit substrate in which a metallic circuit board is joined to at least one surface of a ceramics substrate, and a mounting component is joined to the metallic circuit board. A recess part is formed in the surface of the metallic circuit board, and the mounting component is fit in the recess part, with the bottom of the recess part serving as a junction surface of the mounting component.

### SUMMARY

It is an object of the present invention to provide a power module and a vehicle-mounted power circuit, to resolve poor reliability of the power module caused by a case in which solder in the power module easily overflows into a gap between a chip and an edge of a groove. This object is solved by the subject-matter of the appended independent claims, wherein further embodiments are set out in the dependent claims.

According to a first aspect, an embodiment of this application provides a power module. The power module provided in this embodiment of this application may include a first metal-clad substrate, a chip located on a side of the first metal-clad substrate, and first solder located between the first metal-clad substrate and the chip. A first metal layer is disposed on a surface that is of the first metal-clad substrate and that faces the chip, and the first metal layer may include a groove that penetrates the first metal layer in a thickness direction, and a blocking part. A first thickness of the first metal layer is less than a second thickness. The first thickness is a thickness of at least a part of an area in the blocking part, and the second thickness is a thickness of the first metal layer in an area other than the groove and the blocking part. The blocking part is located between the chip and the adjacent groove, and is configured to prevent the first solder from overflowing into the groove when the chip is welded to the first metal-clad substrate with the first solder.

In the power module provided in this embodiment of this application, the blocking part is disposed at the first metal layer of the first metal-clad substrate, and the blocking part is located between the chip and the adjacent groove. When the chip is welded to the first metal-clad substrate with the first solder, the blocking part can prevent the first solder from overflowing into the groove, to prevent the first solder from overflowing into a gap between the chip and an edge of the groove. This can further prevent the first metal layer from being separated due to stress concentration on the edge of the groove, and improve reliability of the power module. For example, a yield rate of the power module can be improved by at least 5%. In addition, the blocking part is a physical structure at the first metal layer. A material of the first metal layer does not need to be changed, and another material does not need to be added. Therefore, the blocking part has better effect of preventing overflow of the first solder and product reliability is high.

In this embodiment of this application, the first metal-clad substrate may include: a first substrate, the first metal layer located on a side that is of the first substrate and that faces the chip, and a second metal layer located on a side that is of the first substrate and that is away from the chip. The first metal layer and the second metal layer are disposed on two sides of the first substrate, so that the first metal-clad substrate has good heat dissipation performance, and the chip can dissipate heat by using the first metal-clad substrate. The groove at the first metal layer penetrates the first metal layer in the thickness direction. In this way, a line is formed at the first metal layer by disposing the groove. In a specific implementation, in addition to a position adjacent to the chip, the groove may alternatively be disposed at another position, and the groove may be disposed based on a specific layout of the line. A material of the first substrate may be ceramic. Because the first solder is not wetted with a ceramic material, the first solder does not flow into the groove, to prevent the first solder from affecting a line layout of the first metal layer. For example, materials of the first metal layer and the second metal layer may be copper. Certainly, the first metal layer and the second metal layer may alternatively use other materials. This is not limited herein. In a specific implementation, the first metal-clad substrate may be direct bond copper (DBC), active metal brazed copper (AMB, for example, Al₂O₃-AMB, Si₃N₄-AMB, or AlN-AMB), an insulated metal substrate (IMS), or the like. This is not limited herein.

In this embodiment of this application, the chip is interconnected with the first metal-clad substrate by using the first solder, and the chip is welded to the first metal-clad substrate with the first solder. In a welding process, if an amount of the first solder is less than an actually demanded amount, in other words, the amount of the first solder is low, disadvantages such as insufficient solder between the chip and the first metal-clad substrate and a hollow hole on solder may be caused, and heat dissipation performance of the power module is greatly affected. Therefore, in this embodiment of this application, to ensure sufficient solder, the amount of the first solder is slightly greater than the actual amount, in other words, the amount of the first solder is slightly large. In a possible implementation, a material of the first solder may be tin. Certainly, the first solder may alternatively use another material. This is not limited herein.

Because an internal structure of the power module is compact, a distance between the chip and the adjacent groove is close. To prevent the first solder from overflowing into the groove, in this embodiment of this application, the blocking part is disposed between the chip and the adjacent groove. In this way, in a welding process, the blocking part can prevent the first solder from overflowing into the groove, to prevent the first solder from overflowing into the gap between the chip and the edge of the groove. This prevents the first metal layer from being separated due to stress concentration on the edge of the groove, and improves reliability of the power module. In addition, the blocking part does not penetrate the first metal layer. Therefore, disposing the blocking part does not affect the line layout of the first metal layer.

In a specific implementation, adjacent grooves may be disposed on one side, two sides, or three sides of the chip, and may be disposed based on an actual layout of the line. Positions of the grooves are not limited herein. For another side, of the chip, on which no adjacent groove is disposed, overflow of the first solder does not affect stress and the line layout. Therefore, no blocking part may be disposed on the another side, of the chip, on which no adjacent groove is disposed. When a specific structure of the blocking part is disposed, the blocking part may be disposed as a continuous or local structure, or the blocking part may be disposed as a discrete point shape or a discrete line shape.

In some embodiments of this application, the power module may further include a second metal-clad substrate disposed opposite to the first metal-clad substrate, and an interconnection column located between the first metal-clad substrate and the second metal-clad substrate. The chip is located between the first metal-clad substrate and the interconnection column.

Similar to the first metal-clad substrate, the second metal-clad substrate may include a second substrate, a third metal layer located on a side that is of the second substrate and that faces the chip, and a fourth metal layer located on a side that is of the second substrate and that is away from the chip. The third metal layer and the fourth metal layer are disposed on two sides of the second substrate, so that the second metal-clad substrate has good heat dissipation performance, and the chip can dissipate heat by using the second metal-clad substrate. A material of the second substrate may be ceramic, and materials of the third metal layer and the fourth metal layer may be copper. Certainly, the second substrate, the third metal layer, and the fourth metal layer may alternatively use other materials. This is not limited herein. In a specific implementation, the second metal-clad substrate may be direct bond copper (DBC), active metal brazed copper (Active metal brazed copper, AMB, for example, Al₂O₃-AMB, Si₃N₄-AMB, or AlN-AMB), an insulated metal substrate (IMS), or the like. This is not limited herein.

The interconnection column is disposed between the chip and the second metal-clad substrate. The interconnection column has good conductivity and thermal conductivity. For example, the interconnection column may be made of metal, alloy, or a composite material. The interconnection column may perform functions of mechanical connection, electrical connection, and heat conduction, so that the chip may be electrically connected to the second metal-clad substrate, and the chip can dissipate heat by using the second metal-clad substrate. In this way, metal-clad substrates are disposed on two sides of the chip, so that heat generated inside the power module can be discharged from a direction of the first metal-clad substrate and a direction of the second metal-clad substrate, thereby improving heat dissipation performance of the power module.

In a specific implementation, second solder may be disposed between the chip and the interconnection column, and third solder may be disposed between the interconnection column and the second metal-clad substrate, to implement an electrical connection between the chip and the interconnection column, and implement an electrical connection between the interconnection column and the second metal-clad substrate. In a specific implementation, a material that is not wetted with the second solder may be disposed on a surface that is of the chip and that corresponds to a periphery of the interconnection column, to define a position of the second solder. In this way, when the chip is welded to the interconnection column, the second solder can be prevented from spreading to the periphery, and the second solder is prevented from affecting performance of the chip. In a specific implementation, a groove may be disposed at the third metal layer to form a line at the third metal layer. If wiring space of the third metal layer is large, a distance between the interconnection column and a surrounding groove may be long, and the third solder does not overflow into an edge of the groove, and does not affect stress and a line layout of the third metal layer. If the wiring space of the third metal layer is small, the distance between the interconnection column and the surrounding groove may be close, and a blocking part may alternatively be disposed between the interconnection column and the groove of the third metal layer, to prevent the third solder from overflowing into an edge of the groove adjacent to the interconnection column. In this embodiment of this application, for a manner of disposing the blocking part at the third metal layer, refer to the blocking part at the first metal layer. Details are not described herein again.

The blocking part includes at least one recess structure that is recessed towards a first direction. The first direction is a direction in which the chip points to the first metal-clad substrate. By disposing the recess structure, surface tension of the first solder can be used to prevent flow of the first solder, and the recess structure has a specific volume, and overflowed first solder can flow into the recess structure, to buffer the overflowed first solder and prevent the first solder from overflowing into the edge of the groove, to prevent the first solder from overflowing into the groove.

In a manufacturing process of the power module, the recess structure may be formed by using a machining or etching method. A depth of the recess structure is 25% to 75% of the second thickness of the first metal layer. In this way, the recess structure does not penetrate the first metal layer, and the line layout of the first metal layer is not affected. For example, the depth of the recess structure may be 30%, 50%, or 70% of the second thickness, and may be set based on an actual requirement. A specific value of the depth of the recess structure is not limited herein. Certainly, in some cases, the depth of the recess structure may alternatively be less than 25% of the second thickness or greater than 75% of the second thickness, provided that the recess structure does not penetrate the first metal layer.

Alternatively, the blocking part may include one recess structure. The recess structure extends along a second direction, and the second direction is an extension direction of a side that is of the chip and that is adjacent to the blocking part. In other words, the recess structure is a strip structure extending along the second direction. In a specific implementation, a length of the recess structure may be set to be greater than or equal to a length of the side of the corresponding chip, and a width of the recess structure may be set based on a size of space between the corresponding chip and the groove.

In another possible implementation, the blocking part may include a plurality of recess structures. The plurality of recess structures in the blocking part are arranged in at least one row, an arrangement direction of the recess structures is a second direction, and the second direction is an extension direction of a side that is of the chip and that is adjacent to the blocking part. In other words, the blocking part is a strip structure formed by arranging the plurality of recess structures. In a specific implementation, a total length of the plurality of recess structures in the blocking part may be set to be greater than or equal to a length of the side of the corresponding chip, and a quantity of recess structures may be set based on a length required by the blocking part. The width of the recess structure may be set based on a size of space between a corresponding chip and the groove. In actual application, a gap between adjacent recess structures may be set to be small, to prevent the first solder from overflowing through the gap between adjacent recess structures. When the recess structure is specifically disposed, the recess structure may be circular, square, oval, or the like. A shape of the recess structure is not limited herein.

In some other embodiments of this application, the blocking part may include at least one step-shaped structure, and each step-shaped structure includes at least one step. In a specific implementation, the step-shaped structure may include one, two, three, or more steps. This is not limited herein. The step-shaped structure is disposed, steps in the step-shaped structure have a height difference, and a flow path of the first solder can be extended. The surface tension of the first solder can be utilized, so that the first solder flows to an edge of the step-shaped structure and stops, and the first solder is prevented from overflowing into the edge of the groove, to prevent the first solder from flowing into the groove.

In a manufacturing process of the power module, the step-shaped structure may be formed by using a machining or etching method. A thickness of the step-shaped structure is 25% to 75% of the second thickness of the first metal layer. In this way, the step-shaped structure does not penetrate the first metal layer, and the line layout of the first metal layer is not affected. For example, the thickness of the step-shaped structure may be 30%, 50%, or 70% of the second thickness, and may be set based on an actual requirement. A specific value of the thickness of the step-shaped structure is not limited herein. Certainly, in some cases, the thickness of the step-shaped structure may alternatively be less than 25% of the second thickness or greater than 75% of the second thickness d2, provided that the thickness of the step-shaped structure does not penetrate the first metal layer.

In a possible implementation, the blocking part may include one step-shaped structure. The step-shaped structure extends along a second direction, and the second direction is an extension direction of a side that is of the chip and that is adjacent to the blocking part. In other words, the step-shaped structure is a strip structure extending along the second direction. In a specific implementation, a length of the step-shaped structure may be set to be greater than or equal to a length of the side of the corresponding chip, and a width of the step-shaped structure may be set based on a size of space between the corresponding chip and the groove.

In another possible implementation, the blocking part may include a plurality of step-shaped structures, the plurality of step-shaped structures in the blocking part are arranged in at least one row, an arrangement direction of the step-shaped structures is a second direction, and the second direction is an extension direction of a side that is of the chip and that is adjacent to the blocking part. In other words, the blocking part is a strip structure formed by arranging the plurality of step-shaped structures. In a specific implementation, a total length of the plurality of step-shaped structures in the blocking part may be set to be greater than or equal to a length of the side of the corresponding chip, and a quantity of step-shaped structures may be set based on a length required by the blocking part. A width of the step-shaped structure may be set based on a size of space between the corresponding chip and the groove. In actual application, a gap between adjacent step-shaped structures may be set to be small, to prevent the first solder from overflowing through the gap between the adjacent step-shaped structures.

According to a second aspect, an embodiment of this application further provides a vehicle-mounted power circuit. The vehicle-mounted power circuit may include any one of the foregoing power modules and a circuit board. The circuit board is electrically connected to the power module, and the vehicle-mounted power circuit is located in a vehicle-mounted charger or a vehicle-mounted inverter, and is configured to provide a power conversion function for an electric vehicle. In the foregoing power module, a blocking part is disposed at a first metal layer, to prevent first solder from overflowing into a gap between a chip and an edge of a groove. This can further prevent the first metal layer from being separated due to stress concentration on the edge of the groove, and improve reliability of the power module. Therefore, reliability of the vehicle-mounted power circuit including the power module is also high. A problem-resolving principle of the vehicle-mounted power circuit is similar to that of the foregoing power module. Therefore, for implementation of the vehicle-mounted power circuit, refer to the implementation of the foregoing power module. Repeated parts are not described again.

### BRIEF DESCRIPTION OF DRAWINGS

FIG. 1 is a schematic diagram of a cross-sectional structure of a power module according to an embodiment of this application;
FIG. 2 is a schematic diagram of a top-view structure of the power module shown in FIG. 1;
FIG. 3 is another schematic diagram of a top-view structure of the power module shown in FIG. 1;
FIG. 4 is another schematic diagram of a cross-sectional structure of a power module according to an embodiment of this application;
FIG. 5 is a schematic diagram of a top-view structure of the power module shown in FIG. 4; and
FIG. 6 is another schematic diagram of a top-view structure of the power module shown in FIG. 4.

### Reference numerals:

11: first metal-clad substrate; 111: first substrate; 112: first metal layer; 113: second metal layer; 12: chip; 13: first solder; 14: second metal-clad substrate; 141: second substrate; 142: third metal layer; 143: fourth metal layer; 15: interconnection column; 16: second solder; 17: third solder; T: blocking part; t1: recess structure; t2: step-shaped structure; U: groove; F1: first direction; and F2: second direction.

### DESCRIPTION OF EMBODIMENTS

To make objectives, technical solutions, and advantages of this application clearer, the following further describes this application in detail with reference to accompanying drawings.

It should be noted that same reference signs in the accompanying drawings of this application represent same or similar structures, and therefore repeated descriptions thereof are omitted. Words for expressing positions and directions in this application are described by using the accompanying drawings as examples. However, changes may be made as required, and all changes shall fall within the protection scope of this application. The accompanying drawings in this application are merely used to show a relative position relationship, and do not represent a true scale.

Embodiments of this application provide a power module and a vehicle-mounted power circuit. The power module is a semiconductor apparatus that converts a voltage, a current, a frequency, and the like of a power supply. The power module may be used in the vehicle-mounted power circuit, and the vehicle-mounted power circuit may provide a power conversion function for an electric vehicle.

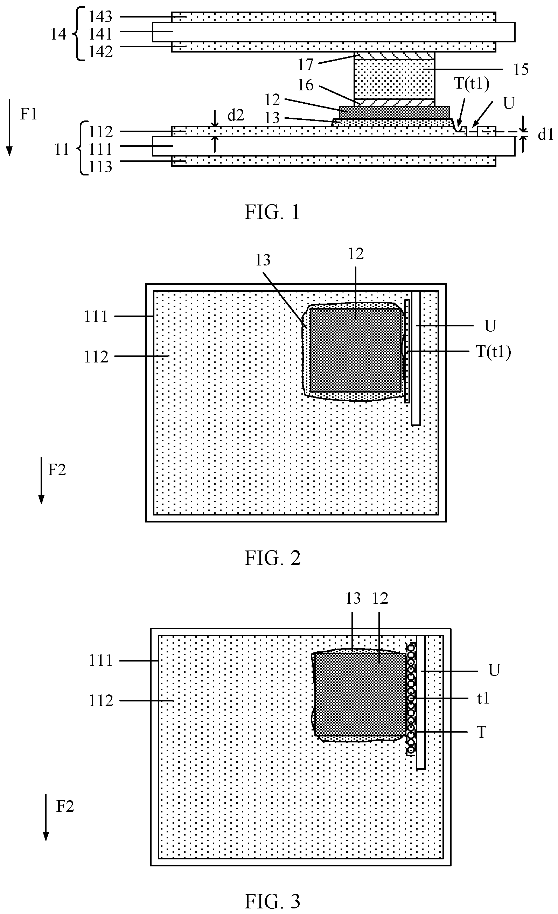

FIG. 1 is a schematic diagram of a cross-sectional structure of a power module according to an embodiment of this application. As shown in FIG. 1, the power module provided in embodiments of this application may include a first metal-clad substrate 11, a chip 12 located on a side of the first metal-clad substrate 11, and first solder 13 located between the first metal-clad substrate 11 and the chip 12. A first metal layer 112 is disposed on a surface that is of the first metal-clad substrate 11 and that faces the chip 12, and the first metal layer 112 may include a groove U that penetrates the first metal layer 112 in a thickness direction, and a blocking part T. A first thickness d1 of the first metal layer 112 is less than a second thickness d2. The first thickness d1 is a thickness of at least a part of an area in the blocking part T, and the second thickness d2 is a thickness of the first metal layer 112 in an area other than the groove U and the blocking part T. The blocking part T is located between the chip 12 and the adjacent groove U, and is configured to prevent the first solder 13 from overflowing into the groove U when the chip 12 is welded to the first metal-clad substrate 11 with the first solder 13.

In the power module provided in embodiments of this application, the blocking part is disposed at the first metal layer of the first metal-clad substrate, and the blocking part is located between the chip and the adjacent groove. When the chip is welded to the first metal-clad substrate with the first solder, the blocking part can prevent the first solder from overflowing into the groove, to prevent the first solder from overflowing into a gap between the chip and an edge of the groove. This can further prevent the first metal layer from being separated due to stress concentration on the edge of the groove, and improve reliability of the power module. For example, a yield rate of the power module can be improved by at least 5%. In addition, the blocking part is a physical structure at the first metal layer. A material of the first metal layer does not need to be changed, and another material does not need to be added. Therefore, the blocking part has better effect of preventing overflow of the first solder and product reliability is high.

In this embodiment of this application, the first metal-clad substrate 11 may include: a first substrate 111, the first metal layer 112 located on a side that is of the first substrate 111 and that faces the chip 12, and a second metal layer 113 located on a side that is of the first substrate 111 and that is away from the chip 12. The first metal layer 112 and the second metal layer 113 are disposed on the two sides of the first substrate 111, so that the first metal-clad substrate 11 has good heat dissipation performance, and the chip 12 can dissipate heat by using the first metal-clad substrate 11. The groove U in the first metal layer 112 penetrates the first metal layer 112 in the thickness direction. In this way, a line is formed at the first metal layer 112 by disposing the groove U. In a specific implementation, in addition to a position adjacent to the chip 12, the groove U may alternatively be disposed at another position, and the groove U may be disposed based on a specific layout of the line. A material of the first substrate 111 may be ceramic. Because the first solder 13 is not wetted with a ceramic material, the first solder 13 does not flow into the groove U, to prevent the first solder 13 from affecting a line layout of the first metal layer 112. For example, materials of the first metal layer 112 and the second metal layer 113 may be copper. Certainly, the first metal layer 112 and the second metal layer 113 may alternatively use other materials. This is not limited herein. In a specific implementation, the first metal-clad substrate 11 may be direct bond copper (DBC), active metal brazed copper (AMB, for example, Al₂O₃-AMB, Si₃N₄-AMB, or AlN-AMB), an insulated metal substrate (IMS), or the like. This is not limited herein.

FIG. 2 is a schematic diagram of a top-view structure of the power module shown in FIG. 1. With reference to FIG. 1 and FIG. 2, the chip 12 is interconnected with the first metal-clad substrate 11 by using the first solder 13, and the chip 12 may be welded to the first metal-clad substrate 11 with the first solder 13. In a welding process, if an amount of the first solder 13 is less than an actually demanded amount, in other words, the amount of the first solder 13 is low, disadvantages such as insufficient solder between the chip 12 and the first metal-clad substrate 11 and a hollow hole on solder may be caused, and heat dissipation performance of the power module is greatly affected. Therefore, in this embodiment of this application, to ensure sufficient solder, the amount of the first solder 13 is slightly greater than the actual amount, in other words, the amount of the first solder 13 is slightly large. In a possible implementation, a material of the first solder 13 may be tin. Certainly, the first solder 13 may alternatively use another material. This is not limited herein.

Still refer to FIG. 1 and FIG. 2. Because an internal structure of the power module is compact, a distance between the chip 12 and the adjacent groove U is close. To prevent the first solder 13 from overflowing into the groove U, in this embodiment of this application, the blocking part T is disposed between the chip 12 and the adjacent groove U. In this way, in a welding process, the blocking part T can prevent the first solder 13 from overflowing into the groove U, to prevent the first solder 13 from overflowing into the gap between the chip 12 and the edge of the groove U. This prevents the first metal layer 112 from being separated due to stress concentration on the edge of the groove U, and improves reliability of the power module. In addition, the blocking part T does not penetrate the first metal layer 112. Therefore, disposing the blocking part T does not affect the line layout of the first metal layer 112.

In FIG. 2, an example in which the adjacent groove U is disposed on a side of the chip 12 is used for illustration. For another side, of the chip 12, on which no adjacent groove U is disposed, overflow of the first solder 13 does not affect stress and the line layout. Therefore, no blocking part may be disposed on the another side, of the chip 12, on which no adjacent groove U is disposed. In a specific implementation, adjacent grooves U may alternatively be disposed on two sides or three sides of the chip 12, and may be disposed based on an actual layout of the line. Positions of the grooves U are not limited herein. When a specific structure of the blocking part T is disposed, the blocking part T may be disposed as a continuous or local structure, or the blocking part T may be disposed as a discrete point shape or a discrete line shape.

As shown in FIG. 1, in some embodiments of this application, the power module may further include a second metal-clad substrate 14 disposed opposite to the first metal-clad substrate 11, and an interconnection column 15 located between the first metal-clad substrate 11 and the second metal-clad substrate 14. The chip 12 is located between the first metal-clad substrate 11 and the interconnection column 15.

Similar to the first metal-clad substrate 11, the second metal-clad substrate 14 may include: a second substrate 141, a third metal layer 142 located on a side that is of the second substrate 141 and that faces the chip 12, and a fourth metal layer 143 located on a side that is of the second substrate 141 and that is away from the chip 12. The third metal layer 142 and the fourth metal layer 143 are disposed on two sides of the second substrate 141, so that the second metal-clad substrate 14 has good heat dissipation performance, and the chip 12 can dissipate heat by using the second metal-clad substrate 14. A material of the second substrate 141 may be ceramic, and materials of the third metal layer 142 and the fourth metal layer 143 may be copper. Certainly, the second substrate 141, the third metal layer 142, and the fourth metal layer 143 may alternatively use other materials. This is not limited herein. In a specific implementation, the second metal-clad substrate 14 may be direct bond copper (DBC), active metal brazed copper (AMB, for example, Al₂O₃-AMB, Si₃N₄-AMB, or AlN-AMB), an insulated metal substrate (IMS), or the like. This is not limited herein.

The interconnection column 15 is disposed between the chip 12 and the second metal-clad substrate 14. The interconnection column 15 has good conductivity and thermal conductivity. For example, the interconnection column 15 may be made of metal, alloy, or a composite material. The interconnection column 15 may perform functions of mechanical connection, electrical connection, and heat conduction, so that the chip 12 may be electrically connected to the second metal-clad substrate 14, and the chip 12 can dissipate heat by using the second metal-clad substrate 14. In this way, metal-clad substrates are disposed on two sides of the chip 12, so that heat generated inside the power module can be discharged from a direction of the first metal-clad substrate 11 and a direction of the second metal-clad substrate 14, thereby improving heat dissipation performance of the power module.

In a specific implementation, second solder 16 may be disposed between the chip 12 and the interconnection column 15, and third solder 17 may be disposed between the interconnection column 15 and the second metal-clad substrate 14, to implement an electrical connection between the chip 12 and the interconnection column 15, and implement an electrical connection between the interconnection column 15 and the second metal-clad substrate 14. In a specific implementation, a material that is not wetted with the second solder 16 may be disposed on a surface that is of the chip 12 and that corresponds to a periphery of the interconnection column 15, to define a position of the second solder 16. In this way, when the chip 12 is welded to the interconnection column 15, the second solder 16 can be prevented from spreading to the periphery, and the second solder 16 is prevented from affecting performance of the chip 12. In a specific implementation, a groove may be disposed at the third metal layer 142 to form a line at the third metal layer 142. If wiring space of the third metal layer 142 is large, a distance between the interconnection column 15 and a surrounding groove may be long, and the third solder 17 does not overflow into an edge of the groove, and does not affect stress and a line layout of the third metal layer 142. If the wiring space of the third metal layer 142 is small, the distance between the interconnection column 15 and the surrounding groove may be close, and a blocking part may alternatively be disposed between the interconnection column 15 and the groove of the third metal layer 142, to prevent the third solder 17 from overflowing into an edge of the groove adjacent to the interconnection column 15. In this embodiment of this application, for a manner of disposing the blocking part at the third metal layer 142, refer to the blocking part at the first metal layer 112. Details are not described herein again.

In some embodiments of this application, as shown in FIG. 1, the blocking part T may include at least one recess structure t1 that is recessed towards a first direction F1. The first direction F1 is a direction in which the chip 12 points to the first metal-clad substrate 11. By disposing the recess structure t1, surface tension of the first solder 13 can be used to prevent flow of the first solder 13, and the recess structure t1 has a specific volume, and overflowed first solder 13 can flow into the recess structure t1, to buffer the overflowed first solder 13 and prevent the first solder 13 from overflowing into the edge of the groove U, to prevent the first solder 13 from overflowing into the groove U.

In a manufacturing process of the power module, the recess structure t1 may be formed by using a machining or etching method. In a specific implementation, a depth of the recess structure t1 may be 25% to 75% of the second thickness d2 of the first metal layer 112. In this way, the recess structure t1 does not penetrate the first metal layer 112, and the line layout of the first metal layer 112 is not affected. For example, the depth of the recess structure t1 may be 30%, 50%, or 70% of the second thickness d2, and may be set based on an actual requirement. A specific value of the depth of the recess structure t1 is not limited herein. Certainly, in some cases, the depth of the recess structure t1 may alternatively be less than 25% of the second thickness d2 or greater than 75% of the second thickness d2, provided that the recess structure t1 does not penetrate the first metal layer 112.

As shown in FIG. 2, in a possible implementation, the blocking part T may include one recess structure t1, and the recess structure t1 extends along a second direction (for example, a direction F2 indicated by an arrow in FIG. 2). The second direction F2 is an extension direction of a side that is of the chip 12 and that is adjacent to the blocking part T. In other words, the recess structure t1 is a strip structure extending along the second direction F2. In a specific implementation, a length of the recess structure t1 may be set to be greater than or equal to a length of the side of the corresponding chip 12, and a width of the recess structure t1 may be set based on a size of space between the corresponding chip 12 and the groove U.

FIG. 3 is another schematic diagram of a top-view structure of the power module shown in FIG. 1. As shown in FIG. 3, in another possible implementation, the blocking part T may include a plurality of recess structures t1. The plurality of recess structures t1 in the blocking part T are arranged in at least one row, an arrangement direction of the recess structures t1 is a second direction (for example, a direction F2 indicated by an arrow in FIG. 3), and the second direction F2 is an extension direction of a side that is of the chip 12 and that is adjacent to the blocking part T. In other words, the blocking part T is a strip structure formed by arranging the plurality of recess structures t1. In a specific implementation, a total length of the plurality of recess structures t1 in the blocking part T may be set to be greater than or equal to a length of the side of the corresponding chip 12, and a quantity of the recess structures t1 may be set based on a length required by the blocking part T. A width of the recess structure t1 may be set based on a size of space between the corresponding chip 12 and the groove U. In actual application, a gap between adjacent recess structures t1 may be set to be small, to prevent the first solder 13 from overflowing through the gap between adjacent recess structures t1. In FIG. 3, an example in which a shape of the recess structure t1 is circular is used for illustration. When the recess structure t1 is specifically disposed, the recess structure t1 may alternatively be in another shape. For example, the recess structure t1 may alternatively be square, oval, or the like. The shape of the recess structure t1 is not limited herein.

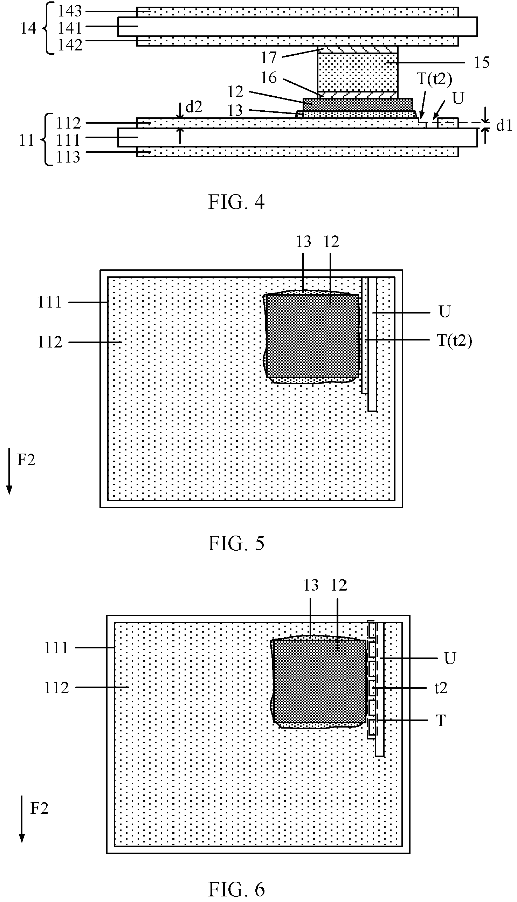

FIG. 4 is another schematic diagram of a cross-sectional structure of a power module according to an embodiment of this application. As shown in FIG. 4, in some other embodiments of this application, the blocking part T may include at least one step-shaped structure t2, and each step-shaped structure t2 includes at least one step. In FIG. 4, an example in which the step-shaped structure t2 includes one step is used for illustration. In a specific implementation, the step-shaped structure t2 may alternatively include two, three, or more steps. This is not limited herein. The step-shaped structure t2 is disposed, steps in the step-shaped structure t2 have a height difference, and a flow path of the first solder 13 can be extended. The surface tension of the first solder 13 can be utilized, so that the first solder 13 flows to an edge of the step-shaped structure t2 and stops, and the first solder 13 is prevented from overflowing into the edge of the groove U, to prevent the first solder 13 from flowing into the groove U.

In a manufacturing process of the power module, the step-shaped structure t2 may be formed by using a machining or etching method. In a specific implementation, a thickness of the step-shaped structure t2 may be 25% to 75% of the second thickness d2 of the first metal layer 112. In this way, the step-shaped structure t2 does not penetrate the first metal layer 112, and the line layout of the first metal layer 112 is not affected. For example, the thickness of the step-shaped structure t2 may be 30%, 50%, or 70% of the second thickness d2, and may be set according to an actual requirement. A specific value of the thickness of the step-shaped structure t2 is not limited herein. Certainly, in some cases, the thickness of the step-shaped structure t2 may be less than 25% of the second thickness d2 or greater than 75% of the second thickness d2, provided that the thickness of the step-shaped structure t2 does not penetrate the first metal layer 112.

FIG. 5 is a schematic diagram of a top-view structure of the power module shown in FIG. 4. As shown in FIG. 5, in a possible implementation, the blocking part T may include one step-shaped structure t2. The step-shaped structure t2 extends along a second direction (for example, a direction F2 indicated by an arrow in FIG. 5). The second direction F2 is an extension direction of a side that is of the chip 12 and that is adjacent to the blocking part T. In other words, the step-shaped structure t2 is a strip structure extending along the second direction F2. In a specific implementation, a length of the step-shaped structure t2 may be set to be greater than or equal to a length of the side of the corresponding chip 12, and a width of the step-shaped structure t2 may be set based on a size of space between the corresponding chip 12 and the groove U.

FIG. 6 is another schematic diagram of a top-view structure of the power module shown in FIG. 4. As shown in FIG. 6, in another possible implementation, the blocking part T may include a plurality of step-shaped structures t2. The plurality of step-shaped structures t2 in the blocking part T are arranged in at least one row, an arrangement direction of the step-shaped structure t2 is a second direction (for example, a direction F2 indicated by an arrow in FIG. 3), and the second direction F2 is an extension direction of a side that is of the chip 12 and that is adjacent to the blocking part T. In other words, the blocking part T is a strip structure formed by arranging the plurality of step-shaped structures t2. In a specific implementation, a total length of the plurality of step-shaped structures t2 in the blocking part T may be set to be greater than or equal to a length of the side of the corresponding chip 12, and a quantity of step-shaped structures t2 may be set based on a length required by the blocking part T. A width of the step-shaped structure t2 may be set based on a size of space between the corresponding chip 12 and the groove U. In actual application, a gap between adjacent step-shaped structures t2 may be set to be small, to prevent the first solder 13 from overflowing through the gap between the adjacent step-shaped structures t2.

Based on a same technical concept, an embodiment of this application further provides a vehicle-mounted power circuit. The vehicle-mounted power circuit may include any one of the foregoing power modules and a circuit board. The circuit board is electrically connected to the power module. The vehicle-mounted power circuit is located in a vehicle-mounted charger or a vehicle-mounted inverter, and is configured to provide a power conversion function for an electric vehicle. In the foregoing power module, a blocking part is disposed at a first metal layer, to prevent first solder from overflowing into a gap between a chip and an edge of a groove. This can further prevent the first metal layer from being separated due to stress concentration on the edge of the groove, and improve reliability of the power module. Therefore, reliability of the vehicle-mounted power circuit including the power module is also high. A problem-resolving principle of the vehicle-mounted power circuit is similar to that of the foregoing power module. Therefore, for implementation of the vehicle-mounted power circuit, refer to the implementation of the foregoing power module. Repeated parts are not described again.

## Claims

1. A power module, comprising: a first metal-clad substrate (11), a chip (12) located on a side of the first metal-clad substrate (11), and first solder (13) located between the first metal-clad substrate (11) and the chip (12), wherein
a first metal layer (112) is disposed on a surface of the first metal-clad substrate (11) facing the chip (12);
the first metal layer (112) comprises a groove (U) that penetrates the first metal layer (112) in a thickness direction, and a blocking part (T);
a first thickness of the first metal layer (112) is less than a second thickness, the first thickness is a thickness of at least a part of an area in the blocking part (T), and the second thickness is a thickness of the first metal layer (112) in an area other than the groove (U) and the blocking part (T); and
the blocking part (T) is located between the chip (12) and the adjacent groove (U), and is configured to prevent the first solder (13) from overflowing into the groove (U) when the chip (12) is welded to the first metal-clad substrate (11) with the first solder (13), wherein the groove (U) is configured to form a line pattern at the first metal layer (112), and the blocking part (T) does not penetrate the first metal layer (112),
wherein the blocking part (T) comprises at least one recess structure (t1) that is recessed towards a first direction (F1), and the first direction (F1) is a direction in which the chip points to the first metal-clad substrate (11), or the blocking part (T) comprises at least one step-shaped structure (t2), and each step-shaped structure (t2) comprises at least one step, and a depth or thickness of the at least one recess structure (t1) or the at least one step-shaped structure (t2) is 25% to 75% of the second thickness of the first metal layer (112).

2. The power module according to claim 1, wherein the blocking part (T) comprises one recess structure (t1), the recess structure (t1) extends along a second direction (F2), and the second direction (F2) is an extension direction of a side of the chip (12) adjacent to the blocking part (T).

3. The power module according to claim 1, wherein the blocking part (T) comprises a plurality of recess structures (t1), the plurality of recess structures (t1) in the blocking part (T) are arranged in at least one row, an arrangement direction of the recess structures (t1) is a second direction (F2), and the second direction (F2) is an extension direction of a side of the chip (12) adjacent to the blocking part (T).

4. The power module according to claim 1, wherein the blocking part (T) comprises one step-shaped structure (t2), the step-shaped structure (t2) extends along a second direction (F2), and the second direction (F2) is an extension direction of a side of the chip (12) adjacent to the blocking part (T).

5. The power module according to claim 1, wherein the blocking part (T) comprises a plurality of step-shaped structures (t2), the plurality of step-shaped structures (t2) in the blocking part (T) are arranged in at least one row, an arrangement direction of the step-shaped structures (t2) is a second direction (F2), and the second direction (F2) is an extension direction of a side of the chip (12) adjacent to the blocking part (T).

6. The power module according to any one of claims 1 to 5, further comprising: a second metal-clad substrate (14) disposed opposite to the first metal-clad substrate (11), and an interconnection column (15) located between the first metal-clad substrate (11) and the second metal-clad substrate (14), wherein
the chip (12) is located between the first metal-clad substrate (11) and the interconnection column (15); and
second solder is disposed between the chip (12) and the interconnection column (15), and third solder is disposed between the interconnection column (15) and the second metal-clad substrate (14).

7. A vehicle-mounted power circuit, comprising the power module according to any one of claims 1 to 6 and a circuit board, wherein the circuit board is electrically connected to the power module; and the vehicle-mounted power circuit is located in a vehicle-mounted charger or a vehicle-mounted inverter, and is configured to provide a power conversion function for an electric vehicle.

## Patentansprüche

1. Leistungsmodul, das umfasst: ein erstes metallkaschiertes Substrat (11), einen Chip (12), der auf einer Seite des ersten metallkaschierten Substrats (11) gelegen ist, und ein erstes Lot (13), das zwischen dem ersten metallkaschierten Substrat (11) und dem Chip (12) gelegen ist, wobei
eine erste Metallschicht (112) auf einer dem Chip (12) zugewandten Oberfläche des ersten metallkaschierten Substrats (11) angeordnet ist;
die erste Metallschicht (112) eine Nut (U), die die erste Metallschicht (112) in einer Dickenrichtung durchdringt, und ein Sperrteil (T) umfasst;
eine erste Dicke der ersten Metallschicht (112) geringer als eine zweite Dicke ist, die erste Dicke eine Dicke von mindestens einem Teil eines Bereichs in dem Sperrteil (T) ist, und die zweite Dicke eine Dicke der ersten Metallschicht (112) in einem anderen Bereich als der Nut (U) und dem Sperrteil (T) ist; und
das Sperrteil (T) zwischen dem Chip (12) und der angrenzenden Nut (U) gelegen und konfiguriert ist, um ein Überlaufen des ersten Lots (13) in die Nut (U) zu verhindern, wenn der Chip (12) mit dem ersten Lot (13) an das erste metallkaschierte Substrat (11) gelötet wird, wobei die Nut (U) konfiguriert ist, um ein Linienmuster an der ersten Metallschicht (112) auszubilden, und das Sperrteil (T) die erste Metallschicht (112) nicht durchdringt, wobei das Sperrteil (T) mindestens eine Aussparungsstruktur (t1) umfasst, die zu einer ersten Richtung (F1) hin ausgespart ist, und die erste Richtung (F1) eine Richtung, in der der Chip auf das erste metallkaschierte Substrat (11) zeigt, ist, oder das Sperrteil (T) mindestens eine stufenförmige Struktur (t2) umfasst, und jede stufenförmige Struktur (t2) mindestens eine Stufe umfasst, und eine Tiefe oder eine Dicke der mindestens einen Aussparungsstruktur (t1) oder der mindestens einen stufenförmigen Struktur (t2) 25 % bis 75 % der zweiten Dicke der ersten Metallschicht (112) beträgt.

2. Leistungsmodul nach Anspruch 1, wobei das Sperrteil (T) eine Aussparungsstruktur (t1) umfasst, die Aussparungsstruktur (t1) sich entlang einer zweiten Richtung (F2) erstreckt und die zweite Richtung (F2) eine Erstreckungsrichtung einer Seite des Chips (12) angrenzend an dem Sperrteil (T) ist.

3. Leistungsmodul nach Anspruch 1, wobei das Sperrteil (T) eine Vielzahl von Aussparungsstrukturen (t1) umfasst, die Vielzahl von Aussparungsstrukturen (t1) in dem Sperrteil (T) in mindestens einer Reihe eingerichtet ist, eine Einrichtungsrichtung der Aussparungsstrukturen (t1) eine zweite Richtung (F2) ist und die zweite Richtung (F2) eine Erstreckungsrichtung einer zu dem Sperrteil (T) angrenzenden Seite des Chips (12) ist.

4. Leistungsmodul nach Anspruch 1, wobei das Sperrteil (T) eine stufenförmige Struktur (t2) umfasst, die stufenförmige Struktur (t2) sich entlang einer zweiten Richtung (F2) erstreckt und die zweite Richtung (F2) eine Erstreckungsrichtung einer Seite des Chips (12) angrenzend an dem Sperrteil (T) ist.

5. Leistungsmodul nach Anspruch 1, wobei das Sperrteil (T) eine Vielzahl von stufenförmigen Strukturen (t2) umfasst, die Vielzahl von stufenförmigen Strukturen (t2) in dem Sperrteil (T) in mindestens einer Reihe eingerichtet ist, eine Einrichtungsrichtung der stufenförmigen Strukturen (t2) eine zweite Richtung (F2) ist und die zweite Richtung (F2) eine Erstreckungsrichtung einer zu dem Sperrteil (T) angrenzenden Seite des Chips (12) ist.

6. Leistungsmodul nach einem der Ansprüche 1 bis 5, das ferner umfasst: ein zweites metallkaschiertes Substrat (14), das gegenüber dem ersten metallkaschierten Substrat (11) angeordnet ist, und eine Verbindungssäule (15), die zwischen dem ersten metallkaschierten Substrat (11) und dem zweiten metallkaschierten Substrat (14) gelegen ist, wobei
der Chip (12) zwischen dem ersten metallkaschierten Substrat (11) und der Verbindungssäule (15) gelegen ist; und
das zweite Lot zwischen dem Chip (12) und der Verbindungssäule (15) gelegen ist, und das dritte Lot zwischen der Verbindungssäule (15) und dem zweiten metallkaschierten Substrat (14) gelegen ist.

7. Fahrzeugmontierter Leistungskreis, der das Leistungsmodul nach einem der Ansprüche 1 bis 6 und eine Leiterplatte umfasst, wobei die Leiterplatte mit dem Leistungsmodul elektrisch verbunden ist; und der fahrzeugmontierte Leistungskreis in einem fahrzeugmontierten Ladegerät oder einem fahrzeugmontierten Umrichter gelegen und konfiguriert ist, um eine Funktion für eine Leistungsumwandlung für ein Elektrofahrzeug bereitzustellen.

## Revendications

1. Module d'alimentation, comprenant : un premier substrat à revêtement métallique (11), une puce (12) située sur un côté du premier substrat à revêtement métallique (11), et une première soudure (13) située entre le premier substrat à revêtement métallique 11) et la puce (12), dans lequel
une première couche métallique (112) est disposée sur une surface du premier substrat à revêtement métallique (11) faisant face à la puce (12) ;
la première couche métallique (112) comprend une rainure (U) qui pénètre dans la première couche métallique (112) dans le sens de l'épaisseur, et une partie de blocage (T) ;
une première épaisseur de la première couche métallique (112) est inférieure à une seconde épaisseur, la première épaisseur est une épaisseur d'au moins une partie d'une zone dans la partie de blocage (T), et la seconde épaisseur est une épaisseur de la première couche métallique (112) dans une zone autre que la rainure (U) et la partie de blocage (T) ; et
la partie de blocage (T) est située entre la puce (12) et la rainure (U) adjacente, et est conçue pour empêcher la première soudure (13) de déborder dans la rainure (U) lorsque la puce (12) est soudée au premier substrat à revêtement métallique (11) avec la première soudure (13), dans lequel la rainure (U) est conçue pour former un motif de ligne au niveau de la première couche métallique (112), et la partie de blocage (T) ne pénètre pas dans la première couche métallique (112),
dans lequel la partie de blocage (T) comprend au moins une structure en retrait (t1) qui est en retrait dans une première direction (F1), et la première direction (F1) est une direction dans laquelle la puce pointe vers le premier substrat à revêtement métallique (11), ou la partie de blocage (T) comprend au moins une structure en forme de marche (t2), et chaque structure en forme de marche (t2) comprend au moins une marche, et une profondeur ou une épaisseur de l'au moins une structure en retrait (T1) ou de l'au moins une structure en forme de marche (T2) est comprise entre 25 % et 75 % de la seconde épaisseur de la première couche métallique (112).

2. Module d'alimentation selon la revendication 1, dans lequel la partie de blocage (T) comprend une structure en retrait (t1), la structure en retrait (t1) s'étend le long d'une seconde direction (F2), et la seconde direction (F2) est une direction d'extension d'un côté de la puce (12) adjacent à la partie de blocage (T).

3. Module d'alimentation selon la revendication 1, dans lequel la partie de blocage (T) comprend une pluralité de structures en retrait (t1), la pluralité de structures en retrait (t1) dans la partie de blocage (T) sont agencées dans au moins une rangée, une direction d'agencement des structures en retrait (t1) est une seconde direction (F2), et la seconde direction (F2) est une direction d'extension d'un côté de la puce (12) adjacent à la partie de blocage (T).

4. Module d'alimentation selon la revendication 1, dans lequel la partie de blocage (T) comprend une structure en forme de marche (t2), la structure en forme de marche (t2) s'étend le long d'une seconde direction (F2), et la seconde direction (F2) est une direction d'extension d'un côté de la puce (12) adjacent à la partie de blocage (T).

5. Module d'alimentation selon la revendication 1, dans lequel la partie de blocage (T) comprend une pluralité de structures en forme de marche (t2), la pluralité de structures en forme de marche (t2) dans la partie de blocage (T) sont agencées dans au moins une rangée, une direction d'agencement des structures en forme de marche (t2) est une seconde direction (F2), et la seconde direction (F2) est une direction d'extension d'un côté de la puce (12) adjacent à la partie de blocage (T).

6. Module d'alimentation selon l'une quelconque des revendications 1 à 5, comprenant en outre : un second substrat à revêtement métallique (14) disposé à l'opposé du premier substrat à revêtement métallique (11), et une colonne d'interconnexion (15) située entre le premier substrat à revêtement métallique (11) et le second substrat à revêtement métallique (14), dans lequel
la puce (12) est située entre le premier substrat à revêtement métallique (11) et la colonne d'interconnexion (15) ; et
une deuxième soudure est disposée entre la puce (12) et la colonne d'interconnexion (15), et une troisième soudure est disposée entre la colonne d'interconnexion (15) et le second substrat à revêtement métallique (14).

7. Circuit d'alimentation monté sur un véhicule, comprenant le module d'alimentation selon l'une quelconque des revendications 1 à 6 et une carte de circuit imprimé, dans lequel la carte de circuit imprimé est connectée électriquement au module d'alimentation ; et le circuit d'alimentation monté sur un véhicule est situé dans un chargeur monté sur un véhicule ou un onduleur monté sur un véhicule, et est configuré pour fournir une fonction de conversion d'alimentation pour un véhicule électrique.
